# EUROPÄISCHE PATENTSCHRIFT

(11) **EP 3 648 318 B1**
(45) Veröffentlichungstag und Bekanntmachung des Hinweises auf die Patenterteilung: **28.07.2021**
(21) Anmeldenummer: 19201041.1
(22) Anmeldetag: 02.10.2019
(51) Int. Cl.: H02K 11/215

(54) **MAGNETHALTER, SENSORMAGNETBAUGRUPPE, ELEKTROMOTOR MIT EINER SENSORMAGNETBAUGRUPPE UND VERFAHREN ZUR HERSTELLUNG EINER SENSORMAGNETBAUGRUPPE**
MAGNET HOLDER, SENSOR MAGNET ASSEMBLY, ELECTRIC MOTOR WITH A SENSOR MAGNET ASSEMBLY AND METHOD FOR PRODUCING A SENSOR MAGNET ASSEMBLY
SUPPORT MAGNÉTIQUE, MODULE D'AIMANT DE DÉTECTION, MOTEUR ÉLECTRIQUE DOTÉ D'UN MODULE D'AIMANT DE DÉTECTION ET PROCÉDÉ DE FABRICATION D'UN MODULE D'AIMANT DE DÉTECTION

(30) Priorität: 29.10.2018 DE 102018218430
(43) Veröffentlichungstag der Anmeldung: 06.05.2020
(73) Patentinhaber: Bühler Motor GmbH, 90459 Nürnberg (DE)
(72) Erfinder: Gehring, Nils, 90765 Fürth (DE); Golditz, Paul-Peter, 90419 Nürnberg (DE); Baudler, Bertram, 90461 Nürnberg (DE); Schneider, Peter, 91220 Schnaittach (DE); Mehl, Gerhard, 91080 Uttenreuth (DE); Kach, Stephan, 91077 Neunkirchen am Brand (DE)

(56) Entgegenhaltungen:
- WO-A1-2017/131296
- JP-A- 2011 160 636
- JP-B2- 5 489 224

## Beschreibung

Die Erfindung betrifft einen Magnethalter (2) zur Befestigung eines Sensormagnten (3) an eine Motorwelle (4) eines Elektromotors (1), mit einer Aufnahmevertiefung (5) für den Sensormagneten (3) und einem Befestigungsbereich (6) zur Befestigung an der Motorwelle (4), wobei die Aufnahmevertiefung (5) von einer Wandung (7) radial begrenzt ist, welche über ihren Umfang mehrere Schwachstellen (8) mit verringerter Wandstärke aufweist, welche derart ausgebildet sind, dass zwischen den Schwachstellen (8) und dem in der Aufnahmevertiefung angeordneten Sensormagneten (3) Freiräume (9) verbleiben. Weiter bezieht sich die Erfindung auf eine Sensormagnetbaugruppe (10), auf einen Elektromotor mit einer Sensormagnetbaugruppe und ein Verfahren zur Herstellung einer Sensormagnetbaugruppe.

Die JP 5 489 224 B2 offenbart einen Magnethalter zur Befestigung eines Sensormagneten an eine Motorwelle eines Elektromotors, mit einer Aufnahmevertiefung für den Sensormagneten und einem Befestigungsbereich zur Befestigung an der Motorwelle, wobei die Aufnahmevertiefung von einer Wandung radial begrenzt ist, welche über ihren Umfang mehrere Schwachstellen aufweist, welche derart ausgebildet sind, dass zwischen den Schwachstellen und dem in der Aufnahmevertiefung angeordneten Sensormagneten Freiräume verbleiben, wobei der Sensormagnet beiderseits der Schwachstellen durch Wandungsbereiche mit größerer Wandstärke formschlüssig in der Aufnahmevertiefung gehalten ist.

Aus der WO 17131296 A1 ist ein gattungsgemäßer Magnethalter, eine Sensormagnetbaugruppe und ein Elektromotor mit der Sensormagnetbaugruppe bekannt. Der Sensormagnet ist dabei rechtwinklig, insbesondere quadratisch ausgebildet und in eine Vertiefung eines Magnethalters eingelegt. Zur Befestigung ist der Sensormagnet eingeklebt. Klebeverfahren weisen eine Reihe von Nachteilen auf. Klebeverbindungen dürfen nicht durch Scherkräfte belastet werden, wie sie beispielhaft durch unterschiedliche Wärmedehnungs- oder Schrumpfungsprozesse verursacht werden. Die Handhabung von Klebstoffen, die Dosierung und die Lagerhaltung ist generell problematisch und sollte wo es möglich ist vermieden werden. Der bekannte Magnethalter ist zudem sehr aufwändig gestaltet und benötigt viel Bauraum.

Eine andere Möglichkeit zur Befestigung eines Sensormagneten ist aus der DE 102 62 404 B3 bekannt. Hier wird ein Sensormagnet durch Heißverstemmen eines Kunststoffträgers fixiert. Diese Lösung ist jedoch nicht ausreichend robust und langlebig.

Aufgabe der vorliegenden Erfindung ist es einen Sensormagneten auf sehr wirtschaftliche und einfache Weise sehr sicher und langlebig am Ende einer Motorwelle zu befestigen, wobei auf Klebeverfahren verzichtet werden soll.

Diese Aufgabe wird erfindungsgemäß durch einen Magnethalter gemäß Anspruch 1, durch eine Sensormagnetbaugruppe gemäß Anspruch 9, durch einen Elektromotor gemäß Anspruch 10 und durch das Verfahren gemäß Anspruch 11 gelöst. Durch den Formschluss an mehreren Stellen der Wandung, welche an diesen Stellen eine große Wandstärke aufweist ist eine sehr sichere und langlebige Verbindung gegeben. Die Schwachstellen 8 werden durch Freiräume 9 begrenzt, die über Nuten 19 mit dem Durchbruch 11 pneumatisch verbunden sind und als Entlüftungsweg beim Aufpressen auf die Motorwelle dienen.

Weiterbildungen der Erfindung werden in den Unteransprüchen dargestellt. Bei einer besonders bevorzugten Weiterbildung der Erfindung besteht der Magnethalter aus einem Sintermaterial, insbesondere aus einem Sintermessing. Mit Hilfe von Sinterverfahren lassen sich auf wirtschaftliche Weise sehr genaue Bauteile herstellen. Im vorliegenden Anwendungsfall ist es zudem wichtig, dass der Magnethalter nichtmagnetisch ist, dies ist z. B. durch die Verwendung von Sintermessing erreichbar. Bei der vorliegenden Anwendung können keine großen Überstände sowohl in Axial- als auch in Radialrichtung geduldet werden, weil dies eine Vergrößerung des Luftspalts und Platzprobleme mit sich bringen würde. Eine mechanische Verformung von Sintermaterial ist bei diesen Verhältnissen schwierig und führt mit herkömmlichen Mitteln und Verfahren zu Materialbrüchen.

Auf Grund der Bruchgefahr wurde vorgeschlagen, dass die Schwachstellen (8) eine minimale Wandungsstärke von maximal 1mm, vorzugsweise maximal 0,8mm aufweisen. Bei Sintermessingteilen ist diese Wandungsstärke gerade noch herstellbar. Durch diese Gestaltung lassen sich Sinterteile leichter verformen, worunter jedoch die Robustheit und Langlebigkeit leidet.

Überraschenderweise ist es gelungen die Eigenschaften der Schwachstellen (8) mit denen der angrenzenden Wandungsbereiche (14) mit größerer Wandungsdicke so zu kombinieren, dass eine einfach und sicher herzustellende Verbindung möglich ist, die zudem eine hohe Festigkeit und Lebensdauer aufweist. Hierzu ist vorgesehen, dass der Sensormagnet (3) rechteckig ist und die Schwachstellen (8) den Ecken oder abgerundeten Ecken des Sensormagneten (3) gegenüber liegen und der Formschluss durch räumlich begrenzte Abschnitte der Wandung (7) beiderseits der Schwachstellen (8) gebildet ist.

Um einen Formschluss herstellen zu können muss die Wandung (7) über abgerundete Kanten (12) des Sensormagneten (3) axial vorspringen. Soweit möglich, sollte die Wandung (7) auch über die Planfläche des Sensormagneten (3) geringfügig vorspringen.

Eine besonders wirtschaftliche Herstellung des Magnethalters ist möglich, wenn auf Hinterschnitte in der Aufnahmevertiefung (5) zur formschlüssigen Fixierung des Sensormagneten (3) verzichtet werden kann. Beim Pressen von Metallpulver lassen sich nämlich keine Hinterschnitte herstellen.

Es ist vorgesehen, dass der Befestigungsbereich (6) buchsenförmig ausgebildet ist und auf die Motorwelle (4) oder einem Absatz der Motorwelle (4) aufgepresst wird. Hierzu ist das vorgesehene Sintermaterial sehr gut geeignet.

Zwischen dem Befestigungsbereich (6) und der Aufnahmevertiefung (5) ist ein Durchbruch (11) ausgebildet. Dieser dient als Entlüftungsöffnung beim Aufpressen. Die Luft kann weiter auch durch die Freiräume an den Ecken entweichen. Je nach Durchmesser der Entlüftungsöffnung ist bereits eine innere Verbindung zwischen diesen Entlüftungswegen vorhanden. Anderenfalls können zusätzliche Vertiefungen im Boden der Aufnahmevertiefung (5) für eine ausreichende Entlüftung sorgen.

Der Sensormagnet weist ein oder zwei Polpaare auf. Um die Magnetorientierung an geometrischen Gegebenheiten ableiten zu können ist vorgesehen, dass die Außenkontur des Magnethalters (2) eine Mehrkantgeometrie, insbesondere ein Vierkantgeometrie aufweist.

Die Aufgabe der Erfindung wird auch durch eine Sensormagnetbaugruppe gelöst, mit dem Magnethalter (2) und dem Sensormagneten (3), welcher in der Aufnahmevertiefung (5) des Magnethalters (2), durch Wandungsabschnitte der Wandung (7) beiderseits der Schwachstellen (8) ausschließlich formschlüssig gehalten ist.

Eine weitere Lösung stellt ein Elektromotor mit einer Sensormagnetbaugruppe dar, wobei die Sensormagnetbaugruppe (10) axial benachbart zur Stirnseite der Motorwelle (4) angeordnet ist.

Schließlich ist die Aufgabe auch durch ein Verfahren zur Herstellung einer Sensormagnetbaugruppe (10) gelöst. Die Verfahrensschritte sind dabei wie folgt: a) Bereitstellen eines gesinterten Magnethalters; b) Bereitstellen eines rechteckigen Sensormagneten (3); c) Einlegen des Magnethalters (2) und des Sensormagneten (3) in eine Pressvorrichtung mit vier Pressbacken; d) Anlegen der Pressbacken an jeweils eine Schwachstelle (8) der Wandung (7) gegenüber den Ecken des Sensormagneten (3); e) Anlegen eines Pressdrucks auf die Schwachstellen (8) mit geringem Vorschub; f) Zurückfahren der Pressbacken; g) Entnehmen der Sensormagnetbaugruppe aus der Pressvorrichtung. Durch dieses Verfahren wird das Sintermaterial teilweise verdichtet, teilweise aber auch verformt, wobei ein ausreichender Formschluss an Bereichen der Wandung entsteht, welche eine größere Wandstärke aufweist als in den Schwachstellen. Damit wird eine ausreichende Festigkeit und Langlebigkeit erreicht.

Eine optimale Anordnung der Pressbacken ist dadurch gegeben, indem diese unter einem Winkel im Bereich von 10 bis 45°, vorzugsweise im Bereich von 15 bis 30°, vorzugsweise um einen Winkel von 20° in Bezug auf die Längsachse der Sensormagnetbaugruppe (10) an die Schwachstellen (8) angelegt werden. Hierdurch kann die Wandung (7) besonders einfach verformt werden.

Ein Ausführungsbeispiel der Erfindung wird nachfolgend anhand der Zeichnung näher erläutert. Es zeigen:
Fig. 1 einen geöffneten Elektromotor mit einer Sensormagnetbaugruppe,
Fig. 2 eine vergrößerte Darstellung der Sensormagnetbaugruppe als Einzelheit W),
Fig. 3 einen Magnethalter vor einer Verformung,
Fig. 4 den Magnethalter nach der Verformung und
Fig. 5 eine Umformvorrichtung.

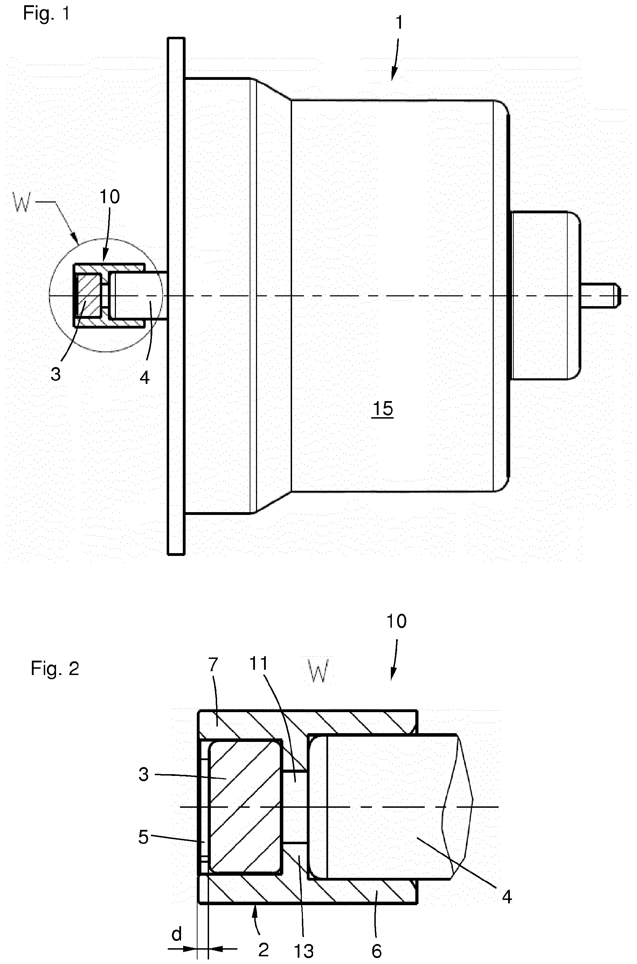

Fig. 1 zeigt einen geöffneten Elektromotor 1 mit einem Motorgehäuse 15, einer Motorwelle 4, einer Sensormagnetbaugruppe 10, bestehend aus einem Magnethalter 2 und einem Sensormagneten 3.

Fig. 2 zeigt eine vergrößerte Darstellung der Sensormagnetbaugruppe 10 (Einzelheit W), mit dem Magnethalter 2, dem Sensormagneten 3 und der Motorwelle 4. Der Sensormagnet 3 ist in eine Aufnahmevertiefung 5 des Magnethalters 2 aufgenommen und mit einem buchsenförmigen Befestigungsbereich 6 auf der Motorwelle 4 aufgepresst. Damit die Einpresstiefe des Magnethalters 2 einerseits und die Einbautiefe des Sensormagneten 3 andererseits definiert ist, ist ein Anschlag 13 vorgesehen, welcher die beiden Bereiche voneinander trennt. Der Anschlag 13 weist einen zentralen Durchbruch 11 auf, um die im Befestigungsbereich 6 eingeschlossene Luft beim Aufpressen des Magnethalters 2 entweichen lassen zu können. Die Aufnahmevertiefung 5 ist durch eine umlaufende Wandung 7 radial begrenzt. Der Magnethalter 2 ist hier im Schnitt in einem unverformten Bereich dargestellt. In diesem Bereich ist die Wandung 7 dickwandig. Die Wandung 7 steht um einen Betrag d über den Sensormagneten 3 vor. Je größer die Verrundungsradien der Ecken und Kanten des Sensormagneten 3 sind, desto geringer kann der Überstand d der Wandung 7 sein. Der Überstand d kann sogar 0 sein.

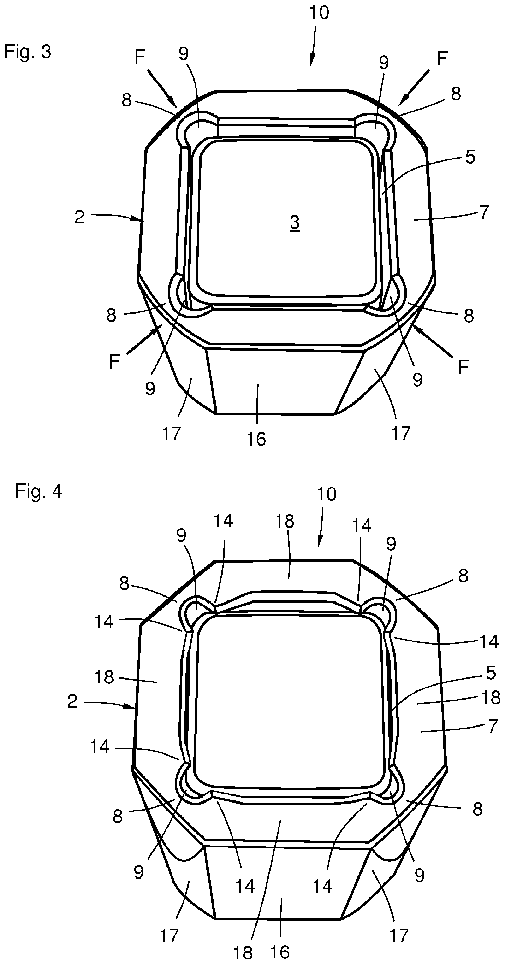

Fig. 3 zeigt den Magnethalter 2 mit dem in der Aufnahmevertiefung 5 aufgenommenen Sensormagneten 3 vor einer Verformung der Wandung 7 der Aufnahmevertiefung 5. Der Sensormagnet ist in seiner Grundform quadratisch und quaderförmig. Die Ecken und Kanten des Sensormagneten sind abgerundet. Die Kanten der Wandung 7 sind mit einer Fase versehen. Die Außenkontur des Magnethalters 2 ist an die Form des Sensormagneten 3 angepasst und mit vier rechtwinklig zueinander ausgerichteten Außenflächen 16 versehen. Übergangsbereiche 17 zwischen den Außenflächen 16 sind bogenförmig ausgebildet. Die Wandung 7 ist in den Übergangsbereichen 17 als Schwachstellen 8 ausgebildet. Die Schwachstellen 8 werden auf der dem Sensormagneten 3 zugewandten Seite durch im Querschnitt viertelkreisförmige Freiräume 9 begrenzt. Durch den Radius des Viertelkreises wird die Kerbwirkung bei einer Verformung und damit die Bruchgefahr minimiert. Durch Pfeile F wird die Kraftrichtung angedeutet, unter welcher erfindungsgemäß Verformungskräfte ausgeübt wird.

Fig. 4 zeigt den Magnethalter 2 nach der Verformung. Hierbei sind Wandungsbereiche 14 beiderseits der Schwachstellen 8 derart radial nach innen verformt, dass sie geringfügig über den Sensormagneten 3 vorragen und eine formschlüssige Verbindung bilden. Zwischenbereiche 18 zwischen den verformten Wandungsbereichen 14 bleiben unverformt. Die Freiräume 9 sind durch die Krafteinwirkung verkleinert aber noch vorhanden, sie dienen zusätzlich der Entlüftung beim Aufpressen der Sensormagnetbaugruppe 10 auf die Motorwelle (hier nicht dargestellt).

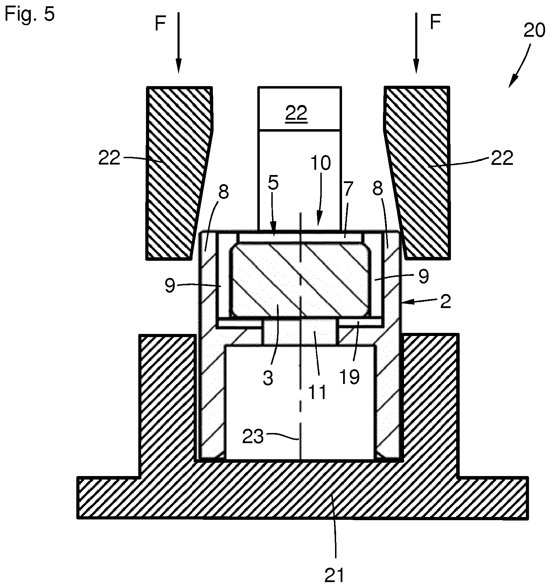

Fig. 5 zeigt eine Umformvorrichtung 20, mit einem Aufnahmeteil 21 zur Aufnahme der Sensormagnetbaugruppe 10 und Druckbacken 22 zur Ausübung einer Druckkraft auf die Schwachstellen 8 der Wandung 7 des Magnethalters 2. Die Druckbacken weisen eine Neigung gegenüber der Mittenachse 23 von ca. 20° auf. Auf diese Weise werden kleine Biegeradien und damit eine Bruchgefahr vermieden. Die Sensormagnetbaugruppe 10 ist hier gegenüber Fig. 2 um 45° gedreht dargestellt, so dass der Schnitt durch die Schwachstellen 8 verläuft. Die Schwachstellen 8 werden durch Freiräume 9 begrenzt, die über Nuten 19 mit dem Durchbruch 11 pneumatisch verbunden sind und als Entlüftungsweg beim Aufpressen auf die Motorwelle dienen.

### Bezugszeichenliste

- 1: Elektromotor
- 2: Magnethalter
- 3: Sensormagnet
- 4: Motorwelle
- 5: Aufnahmevertiefung
- 6: Befestigungsbereich
- 7: Wandung
- 8: Schwachstelle
- 9: Freiraum
- 10: Sensormagnetbaugruppe
- 11: Durchbruch
- 12: Kante
- 13: Anschlag
- 14: Wandungsbereich
- 15: Motorgehäuse
- 16: Außenfläche
- 17: Übergangsbereich
- 18: Zwischenbereich
- 19: Nut
- 20: Umformvorrichtung
- 21: Aufnahmeteil
- 22: Druckbacken

## Patentansprüche

1. Magnethalter (2) zur Befestigung eines Sensormagneten (3) an eine Motorwelle (4) eines Elektromotors (1), mit einer Aufnahmevertiefung (5) für den Sensormagneten (3) und einem Befestigungsbereich (6) zur Befestigung an der Motorwelle (4), wobei ein Anschlag (13) die Aufnahmevertiefung (5) und den Befestigungsbereich (6) voneinander trennt und einen Durchbruch (11) aufweist, wobei die Aufnahmevertiefung (5) von einer Wandung (7) radial begrenzt ist, welche über ihren Umfang mehrere Schwachstellen (8) mit verringerter Wandstärke aufweist, welche derart ausgebildet sind, dass zwischen den Schwachstellen (8) und dem in der Aufnahmevertiefung (5) angeordneten Sensormagneten (3) Freiräume (9) verbleiben, wobei der Sensormagnet (3) beiderseits der Schwachstellen (8) durch Wandungsbereiche (14) mit größerer Wandstärke formschlüssig in der Aufnahmevertiefung (5) gehalten ist und wobei die Freiräume (9) über Nuten (19) mit dem Durchbruch (11) pneumatisch verbunden sind und als Entlüftungsweg beim Aufpressen auf die Motorwelle dienen.

2. Magnethalter nach Anspruch 1, **dadurch gekennzeichnet, dass** er aus einem magnetisch nichtleitenden Sintermetall, insbesondere Sintermessing besteht.

3. Magnethalter nach Anspruch 2, **dadurch gekennzeichnet, dass** die Schwachstellen (8) eine minimale Wandungsstärke von maximal 1mm, vorzugsweise maximal 0,8mm aufweisen.

4. Magnethalter nach Anspruch 1, 2 oder 3, **dadurch gekennzeichnet, dass** der Sensormagnet (3) rechteckig ist und die Schwachstellen (8) den Ecken oder abgerundeten Ecken des Sensormagneten (3) gegenüber liegen und der Formschluss durch räumlich begrenzte Abschnitte der Wandung (7) beiderseits der Schwachstellen (8) gebildet ist.

5. Magnethalter nach Anspruch 1, 2, 3 oder 4, **dadurch gekennzeichnet, dass** die Wandung (7) über abgerundete Kanten (12) des Sensormagneten (3) axial vorspringt.

6. Magnethalter nach zumindest einem der vorangehenden Ansprüche, **dadurch gekennzeichnet, dass** die Aufnahmevertiefung (5) vor der Montage des Sensormagneten (3) keine Hinterschnitte aufweist.

7. Magnethalter nach zumindest einem der vorangehenden Ansprüche, **dadurch gekennzeichnet, dass** der Befestigungsbereich (6) buchsenförmig ausgebildet ist und zum Aufpressen auf die Motorwelle (4) oder einem Absatz der Motorwelle (4) dient.

8. Magnethalter nach zumindest einem der vorangehenden Ansprüche, **dadurch gekennzeichnet, dass** die Außenkontur des Magnethalters (2) eine Mehrkantgeometrie, insbesondere ein Vierkantgeometrie aufweist.

9. Sensormagnetbaugruppe mit dem Magnethalter (2) nach einem der Ansprüche 1 bis 8 und dem Sensormagneten (3), welcher in der Aufnahmevertiefung (5) des Magnethalters (2), ausschließlich formschlüssig durch Wandungsabschnitte der Wandung (7) beiderseits der Schwachstellen (8) gehalten ist.

10. Elektromotor mit einer Sensormagnetbaugruppe gemäß Anspruch 9, **dadurch gekennzeichnet, dass** die Sensormagnetbaugruppe (10) axial benachbart zur Stirnseite der Motorwelle (4) angeordnet ist.

11. Verfahren zur Herstellung einer Sensormagnetbaugruppe (10) gemäß Anspruch 9, **gekennzeichnet durch** folgende Verfahrensschritte: a) Bereitstellen eines gesinterten Magnethalters; b) Bereitstellen eines rechteckigen Sensormagneten (3); c) Einlegen des Magnethalters (2) und des Sensormagneten (3) in eine Pressvorrichtung mit vier Pressbacken; d) Anlegen der Pressbacken an jeweils eine Schwachstelle (8) der Wandung (7) gegenüber den Ecken des Sensormagneten (3); e) Anlegen eines Pressdrucks auf die Schwachstellen (8) mit geringem Vorschub; f) Zurückfahren der Pressbacken; g) Entnehmen der Sensormagnetbaugruppe (10) aus der Pressvorrichtung.

12. Verfahren zur Herstellung einer Sensormagnetbaugruppe (10) gemäß Anspruch 11, **dadurch gekennzeichnet, dass** die Pressbacken unter einem Winkel im Bereich von 10 bis 45°, vorzugsweise im Bereich von 15 bis 30°, vorzugsweise um einen Winkel von 20° in Bezug auf die Längsachse der Sensormagnetbaugruppe (10) an die Schwachstellen (8) angelegt werden.

## Claims

1. A magnet holder (2) for fastening a sensor magnet (3) to a motor shaft (4) of an electric motor (1), with a receiving recess (5) for the sensor magnet (3) and a fastening region (6) for fastening to the motor shaft (4), wherein a stop (13) separates the receiving recess (5) and the fastening region (6) from each other and has an opening (11),
wherein the receiving recess (5) is radially limited by a wall (7) which has over its periphery a plurality of weak points (8) of reduced wall thickness which are formed such that free spaces (9) remain between the weak points (8) and the sensor magnet (3) arranged in the receiving recess (5), wherein the sensor magnet (3) on either side of the weak points (8) is held in a form-fit in the receiving recess (5) by wall regions (14) of a greater wall thickness and wherein the free spaces (9) are pneumatically connected to the opening (11) by way of grooves (19) and serve as a ventilation path during pressing onto the motor shaft.

2. A magnet holder according to claim 1, **characterised in that** it consists of a magnetically non-conductive sintered metal, in particular sintered brass.

3. A magnet holder according to claim 2, **characterised in that** the weak points (8) have a minimum wall thickness of at most 1 mm, preferably at most 0.8 mm.

4. A magnet holder according to claim 1, 2 or 3, **characterised in that** the sensor magnet (3) is rectangular and the weak points (8) are located opposite the corners or rounded-off corners of the sensor magnet (3) and the form-fit is formed by spatially limited portions of the wall (7) on either side of the weak points (8).

5. A magnet holder according to claim 1, 2, 3 or 4, **characterised in that** the wall (7) projects axially over rounded-off edges (12) of the sensor magnet (3).

6. A magnet holder according to at least one of the preceding claims, **characterised in that** the receiving recess (5) does not have any undercuts prior to mounting the sensor magnet (3).

7. A magnet holder according to at least one of the preceding claims, **characterised in that** the fastening region (6) is in the form of a bushing and serves for pressing on the motor shaft (4) or a shoulder of the motor shaft (4).

8. A magnet holder according to at least one of the preceding claims, **characterised in that** the outer contour of the magnet holder (2) has a polygonal geometry, in particular a quadrilateral geometry.

9. A sensor magnet assembly with the magnet holder (2) according to one of claims 1 to 8, and with the sensor magnet (3), which is held in the receiving recess (5) of the magnet holder (2) exclusively in a form-fit by wall portions of the wall (7) on both sides of the weak points (8).

10. An electric motor with a sensor magnet assembly according to claim 9, **characterised in that** the sensor magnet assembly (10) is arranged axially adjacent to the end face of the motor shaft (4).

11. A method for producing a sensor magnet assembly (10) according to claim 9, **characterised by** the following method steps: a) providing a sintered magnet holder; b) providing a rectangular sensor magnet (3); c) placing the magnet holder (2) and the sensor magnet (3) into a pressing device with four pressing jaws; d) applying the pressing jaws against one weak point (8) in each case of the wall (7) opposite the corners of the sensor magnet (3); e) applying pressure to the weak points (8) with little advance; f) retracting the pressing jaws; g) removing the sensor magnet assembly (10) from the pressing device.

12. A method for producing a sensor magnet assembly (10) according to claim 11, **characterised in that** the pressing jaws are applied to the weak points (8) at an angle in the range from 10 to 45°, preferably in the range from 15 to 30°, preferably by an angle of 20° relative to the longitudinal axis of the sensor magnet assembly (10).

## Revendications

1. Support d'aimant (2) pour la fixation d'un aimant capteur (3) à un arbre de moteur (4) d'un moteur électrique (1), avec un évidement de réception (5) pour l'aimant capteur (3) et une zone de fixation (6) pour la fixation à l'arbre de moteur (4), où une butée (13) sépare l'évidement de réception (5) et la zone de fixation (6) l'un de l'autre et présente une ouverture (11), où l'évidement de réception (5) est limité radialement par une paroi (7) qui présente sur sa circonférence plusieurs points faibles (8) avec une épaisseur de paroi réduite, qui sont conçus de telle manière que des espaces libres (9) demeurent entre les points faibles (8) et l'aimant capteur (3) disposé dans l'évidement de réception (5), où l'aimant capteur (3) est maintenu par assemblage de forme dans l'évidement de réception (5) des deux côtés des points faibles (8) par des zones de paroi (14) avec une plus grande épaisseur de paroi, et où les espaces libres (9) sont reliés pneumatiquement par le biais de rainures (19) avec l'ouverture (11) et servent de chemin de désaération lors du montage par pression sur l'arbre de moteur.

2. Support d'aimant selon la revendication 1, **caractérisé en ce qu'**il consiste en un métal fritté magnétiquement non conducteur, notamment en laiton fritté.

3. Support d'aimant selon la revendication 2, **caractérisé en ce que** les points faibles (8) présentent une épaisseur de paroi minimale d'au maximum 1 mm, de préférence d'au maximum 0,8 mm.

4. Support d'aimant selon la revendication 1, 2 ou 3, **caractérisé en ce que** l'aimant capteur (3) est rectangulaire et les points faibles (8) sont situés en face des angles ou des angles arrondis de l'aimant capteur (3) et l'assemblage de forme est formé par des sections spatialement limitées de la paroi (7) des deux côtés des points faibles (8).

5. Support d'aimant selon la revendication 1, 2, 3 ou 4, **caractérisé en ce que** la paroi (7) fait saillie axialement au-dessus des bords arrondis (12) de l'aimant capteur (3).

6. Support d'aimant selon au moins l'une des revendications précédentes, **caractérisé en ce que** l'évidement de réception (5) ne présente pas de contre-dépouilles avant le montage de l'aimant capteur (3).

7. Support d'aimant selon au moins l'une des revendications précédentes, **caractérisé en ce que** la zone de fixation (6) est en forme de douille et sert au montage par pression sur l'arbre de moteur (4) ou un épaulement de l'arbre de moteur (4).

8. Support d'aimant selon au moins l'une des revendications précédentes, **caractérisé en ce que** le contour extérieur du support d'aimant (2) présente une géométrie polygonale, notamment une géométrie carrée.

9. Ensemble à aimant capteur avec le support d'aimant (2) selon l'une des revendications 1 à 8 et l'aimant capteur (3), qui est maintenu dans l'évidement de réception (5) du support d'aimant (2) exclusivement par assemblage de forme par des sections de paroi de la paroi (7) des deux côtés des points faibles (8).

10. Moteur électrique avec un ensemble à aimant capteur selon la revendication 9, **caractérisé en ce que** l'ensemble à aimant capteur (10) est disposé axialement au voisinage du côté frontal de l'arbre de moteur (4).

11. Procédé de fabrication d'un ensemble à aimant capteur (10) selon la revendication 9, **caractérisé par** les étapes de procédé suivantes: a) mise à disposition d'un support d'aimant fritté; b) mise à disposition d'un aimant capteur rectangulaire (3); c) insertion du support d'aimant (2) et de l'aimant capteur (3) dans un dispositif de pressage avec quatre mâchoires de pressage; d) application des mâchoires de pressage sur un point faible (8) de la paroi (7) en face des angles de l'aimant capteur (3); e) application d'une pression de pressage sur les points faibles (8) avec une faible avance; f) rétraction des mâchoires de pressage; g) retrait de l'ensemble à aimant capteur (10) du dispositif de pressage.

12. Procédé de fabrication d'un ensemble à aimant capteur (10) selon la revendication 11, **caractérisé en ce que** les mâchoires de pressage sont appliquées sur les points faibles (8) sous un angle dans le domaine de 10 à 45°, de préférence dans le domaine de 15 à 30°, de préférence sous un angle de 20° par rapport à l'axe longitudinal de l'ensemble à aimant capteur (10).
